(19) Europäisches Patentamt
European Patent Office
Office européen des brevets

(11) Numéro de publication: **0 018 260**
**B1**

(12) # FASCICULE DE BREVET EUROPEEN

(45) Date de publication du fascicule du brevet: **23.03.83**

(51) Int. Cl.³: **C 23 C 11/00**, C 23 C 11/08

(21) Numéro de dépôt: **80400446.3**

(22) Date de dépôt: **03.04.80**

(54) **Procédé et appareillage pour fabriquer des filaments en matière réfractaire par chauffage haute fréquence.**

(30) Priorité: **24.04.79 FR 7910334**

(43) Date de publication de la demande: **29.10.80 Bulletin 80/22**

(45) Mention de la délivrance du brevet: **23.03.83 Bulletin 83/12**

(84) Etats contractants désignés: **DE FR GB IT NL SE**

(56) Documents cités:
**FR-A-1 564 841**
**FR-A-2 036 618**
**FR-A-2 065 430**
**FR-A-2 243 907**
**US-A-3 409 469**
**US-A-3 572 286**
**US-A-3 677 799**
**US-A-4 098 920**

(73) Titulaire: **SOCIETE NATIONALE DES POUDRES ET EXPLOSIFS, 12, quai Henri IV, F-75181 Paris Cedex 04 (FR)**

(72) Inventeur: **Grange, André, Ecole Publique, F-91710 Vert le Petit (FR)**
Inventeur: **Corbe, Jean, 17, rue de la Station, F-91610 Ballancourt (FR)**

**EP 0 018 260 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Procédé et appareillage pour fabriquer des filaments en matière réfractaire par chauffage haute fréquence

La présente invention se rapporte à un procédé et un appareillage permettant de déposer en continu des matières réfractaires, notamment du bore, sur un filament conducteur chauffé par effet Joule et par un courant haute fréquence.

Il est connu d'utiliser un procédé consistant à faire passer un filament conducteur appelé substrat, chauffé par effet Joule, au travers d'une chambre de réaction cylindrique, disposée horizontalement ou verticalement; la chambre de réaction est munie d'un dispositif d'entrée et d'un dispositif de sortie, munis d'un joint conducteur permettant l'introduction du mélange gazeux, assurant l'étanchéité vis à vis de l'atmosphère extérieur et le passage du courant électrique nécessaire au chauffage par effet Joule. Dans le cas du dépôt de bore, le mélange gazeux est généralement composé de trichlorure de bore et d'hydrogène. La réaction s'effectue alors de la manière suivante:

$$2\ BCl_3 + 3\ H_2 \rightarrow 2\ B + 6\ HCl$$

Toutefois, ce procédé présente certains inconvénients du fait que la température à laquelle est chauffé le filament décroit sensiblement tout au long du réacteur dans le sens du défilement du substrat. Cela a pour conséquence néfaste de faire varier dans le même sens (décroissant) la vitesse de dépôt de la matière réfractaire sur le filament conducteur.

Ainsi, la température du filament qui est habituellement de 1100 à 1250° C en début de réaction passe à 950° C—1000° C en fin de réacteur. De ce fait, la vitesse de dépôt qui est de 4 à 6 µm/s en début de réacteur décroit jusqu'à moins de 1 µm/s en fin de réacteur.

En outre, la température extrême à laquelle peut être chauffé le filament conducteur est, dans ce dispositif, limitée par la tendance à la cristallisation de la matière réfractaire, donnant ainsi une fibre aux propriétés mécaniques très faibles.

Diverses solutions ont été proposées à ce jour, pour palier à ces inconvénients.

Il a été notamment proposé dans le brevet US 2 656 283 de séparer le réacteur en plusieurs chambres de réaction avec des alimentations électriques séparées.

Toutefois, un tel procédé entraine une hétérogénéité du dépôt préjudiciable aux caractéristiques mécaniques de la fibre obtenue. De plus, les difficultés opératoires de réintroduction du filament, lorsqu'il se produit une rupture, limitent la rentabilité.

Il a été, aussi, proposé d'adjoindre un four autour du réacteur afin de limiter les pertes thermiques en réchauffant progressivement les gaz vers la sortie du réacteur. Ce procédé est notamment décrit dans le brevet français n° 2 170 952. Mais encore une fois l'exploitation industrielle d'un tel procédé est rendue difficile à cause de la faible stabilité du système. En effet, le réchauffement des gaz provoque un dépôt de bore ou d'autres matières réfractaires sur les parois du réacteur provoquant ainsi une modification des caractéristiques thermiques comme l'émissivité et la conductivité. En outre, ce procédé présente à nouveau certaines difficultés de réintroduction du filament du fait de la température élevée des parois du réacteur.

Enfin deux documents proposent d'utiliser un système de chauffage haute fréquence par induction.

Le chauffage par induction permet le transfert de l'énergie haute fréquence sans contact physique, par couplage électro magnétique entre inducteur et fibre.

Le brevet US 3 811 940 propose d'utiliser un système de chauffage par une ou plusieurs cavités haute fréquence.

Le brevet US 4 098 920 décrit un procédé utilisant la combinaison d'un chauffage par effet Joule et d'un chauffage par induction d'un courant haute fréquence assuré au moyen d'une antenne extérieure.

Mais ces dispositif présentent certains inconvénients. En effet, un couplage stable entre la fibre et le moyen de chauffage haute fréquence par induction est très difficile à obtenir à cause des faibles dimensions du filament par rapport à celles du moyen. Ceci conduit à utiliser des moyens à très fort coefficient de surtension, ayant des caractéristiques géométriques stables et précises.

Ces systèmes sont, par ailleurs, peu stables du fait que l'introduction du filament de départ, l'augmentation de diamètre de la fibre et les dilatations thermiques influent sur l'accord de la cavité et nécessitent de constantes retouches. L'utilisation d'un moyen à très fort coefficient de surtension entraîne aussi la nécessité de travailler avec des tensions HF élevées et accroît ainsi les pertes et les rayonnements parasites. Le règlage d'un tel moyen est en outre délicat et tout déplacement du maximum de l'intensité provoque une surchauffe du filament et de faibles propriétés mécaniques.

Il a maintenant été trouvé que la combinaison du chauffage par effet Joule et du chauffage par haute fréquence direct à l'aide d'un dispositif original permettait de remédier aux inconvénients précédents. Dans le chauffage direct, l'injection de l'énergie haute fréquence se fait directement, par l'intermédiaire d'un conducteur, sur la fibre utilisée elle-même comme conducteur.

L'objet de la présente invention est donc de permettre à la fois un dépôt régulier de bore ou d'autres matières réfractaires sur le filament conducteur, d'augmenter considérablement le diamètre de ce filament, tout en augmentant la résistance à la traction de ces filaments.

Un autre objet de la présente invention est de permettre d'augmenter la puissance de chauffage,

sans pour cela provoquer une diminution des propriétés mécaniques du filament obtenu.

Selon la présente invention le procédé pour déposer en continu des matières réfractaires, notamment, du bore, à partier d'un mélange gazeux décomposable par pyrolyse, sur un filament conducteur chauffé par effet Joule, défilant au travers d'un réacteur tubulaire, est caractérisé en ce que on augmente la température du filament dans une partie choisie du réacteur au moyen d'un courant haute fréquence injecté directement sur ledit filament.

Dans la description qui va suivre on désignera, indifféremment par filament conducteur le fil qui est recouvert par la matière réfractaire lors de son passage au travers du réacteur et le fil qui n'a pas encore été recouvert au moment de son entrée dans le réacteur.

Il est, en effet, évident pour l'homme de métier que le contact électrique s'établit sur le filament conducteur non recouvert de matière réfractaire à l'entrée du réacteur et sur ce même filament recouvert à la sortie du réacteur.

Selon un mode opératoire général, le filament conducteur est tiré à une vitesse constante à travers un réacteur tubulaire de longueur déterminée dans lequel circule un mélange gazeux réactif.

L'étanchéité du dispositif est assurée par deux pipettes remplies d'un liquide de grande tension superficielle et conducteur, par exemple, le mercure. Le chauffage s'effectue par deux dispositifs combinés:

1 Par l'intermédiaire d'une alimentation haute tension continue, règlable suivant le substrat utilisé et la longueur du réacteur;
2 Par l'intermédiaire d'un courant haute fréquence produit à l'aide d'un générateur, injecté directement sur le filament et permettant d'augmenter sélectivement la température dans la partie du réacteur que l'on a choisie.

On entend par »injecter« le fait que le courant haute fréquence est transmis au filament conducteur.

La longueur du réacteur est fonction de la longueur d'onde du courant haute fréquence utilisée. Il est généralement admis qu'une longueur de réacteur comprise entre $\lambda/2$ et $\lambda/4$ est particulièrement adaptée pour le chauffage par haute fréquence.

Le domaine de longueur d'onde utilisée peut varier dans une large gamme. On utilisera de préférence des longueurs d'ondes variant entre 10 m et 1 m.

Le substrat conducteur peut être fait de n'importe laquelle des matières utilisées de façon classique comme substrat pour le dépôt de matière réfractaire. On peut citer à titre indicatif le tungstène, le titane, le zirconium, le carbone, le fer, l'acier, le molybdène, le nickel.

Mis à part le bore, on peut citer comme autres matières réfractaires le carbure de silicium ou le diborure de titane, par exemple.

Habituellement, la température de dépôt, c'est à dire la température à laquelle le filament est chauffé est comprise entre 950° C et 1250° C.

Selon un procédé préféré, il a été trouvé qu'il était avantageux d'utiliser une puissance de chauffage totale, c'est à dire une puissance correspondant à la somme de la puissance courant continu et de la puissance haute fréquence, supérieure à la puissance maximum utilisable avec le procédé conventionnel en courant continu qui est de l'ordre de 180 W pour un réacteur de 50 cm de long. Cet accroissement de puissance permet d'augmenter le diamètre du filament et sa résistance mécanique à la rupture, par rapport au procédé avec chauffage par courant continu. L'augmentation de la puissance injectée peut ainsi être de l'ordre de 80%, entraînant un doublement de la masse de bore déposée.

Selon un autre mode préféré, il est avantageux de faire varier la température de manière croissante et continue du début à la fin du réacteur.

Cette réalisation particulière a pour conséquence l'obtention d'un filament présentant une résistance à la rupture bien supérieure à celle obtenue par le procédé classique et ceci avec des vitesses de fabrication supérieures.

En outre, le fait d'opérer à température faible pour la première phase du dépôt permet de limiter la tendance au dépôt cristallin, le nombre de défauts à l'interface substance réfractaire-substrat et les contraintes afférantes.

Il est possible ainsi de déposer du bore ou d'autres matières réfractaires à partir de matières premières de qualité moindre que celles nécessaires au procédé classique et ainsi d'abaisser les coûts de fabrication sans nuire aux propriétés mécaniques.

Il a été trouvé qu'il était particulièrement avantageux d'injecter le courant haute fréquence en fin de réacteur, de préférence au niveau de la pièce de sortie, du réacteur, afin d'augmenter la température du filament dans la deuxième partie du réacteur.

La présente invention a également pour objet un appareillage permettant d'effectuer le dépôt, à partier d'un mélange gazeux décomposable par pyrolyse, de matières réfractaires, notamment du bore, sur un filament conducteur chauffe par resistance et au moyen d'un chauffage par haute fréquence, ledit appareillage étant constitué d'une chambre de réaction tubulaire, de moyens de fermeture aux deux extrémités de la chambre fonctionnant suivant le principe de la capillarité pour réaliser à la fois un scellage et un contact électrique en vue du chauffage, un moyen d'entrée pour fournir le mélange gazeux réactif à la chambre et un moyen de sortie pour évacuer les sous produits et

l'excès de gaz réagissant, et caractérisé en ce que ledit dispositif est combiné avec un moyen de chauffage par haute fréquence couplé directement au filament conducteur.

De manière générale les moyens de fermeture à chaque extrémité du réacteur comportent une partie formant bouchon ou joint ayant un compartiment à liquide rempli d'un fluide conducteur ayant des caractéristiques de grande tension superficielle, de préférence du mercure, chaque compartiment à liquide se terminant par un orifice restreint de façon à réaliser une ouverture (c'est-à-dire un orifice, une fente, etc...) qui est suffisamment large pour permettre le passage continu d'un filament au travers mais qui est suffisamment petite pour limiter le passage, au travers, du fluide conducteur contenu dans le compartiment à liquide. Dans le cas du bouchon de sortie, l'ouverture doit être suffisamment large pour permettre le passage du filament recouvert.

La chambre de réaction tubulaire est par exemple en verre.

Les moyens d'entrée et de sortie du mélange réactif sont constitués de préférence par des tubes insérés dans les moyens de fermeture, passant à travers ceux-ci jusqu'à la chambre de réaction.

Il est avantageux d'injecter le courant haute fréquence sur le filament par l'intermédiaire du moyen de fermeture associé à un dispositif relié à la masse par un système capacitif et placé à une distance telle de l'endroit où le courant haute fréquence est injecté qu'il permet d'éviter toute fuite de l'énergie haute fréquence vers le dispositif d'enroulement.

Le courant haute fréquence produit par le moyen de chauffage haute fréquence peut être injecté à n'importe quel endroit du filament conducteur en pratiquant une traversée dans le réacteur et en insérant par cette traversée un contact branché sur le filament.

Il est toutefois particulièrement avantageux d'injecter ce courant haute fréquence à la sortie du réacteur au niveau du moyen de fermeture. Cela permet, en effet, d'améliorer considérablement le chauffage du filament dans la deuxième partie du réacteur. D'autres avantages de cette réalisation seront mieux compris à l'aide des exemples que l'on trouvera à la fin de cette description.

La description qui va suivre en regard de la figure annexée, donnée à titre d'exemple non limitatif, fera bien comprendre comment l'invention peut être mise en oeuvre. Les particularités qui ressortent tant de la figure que du texte faisant, bien entendu, partie de la présente invention.

La figure annexée est une vue en coupe d'un mode de réalisation de l'appareillage particulèrement approprié pour être utilisé dans la mise en oeuvre de l'invention.

Selon la figure annexée, l'appareillage est constitué:

- d'un système de distribution du mélange réactif $H_2-BCl_3$ comportant deux débitmètres 1 et 2 de capacités respectives à 600 l/h et à 300 l/h pour l'hydrogène et le trichlorure de bore,
- d'un réacteur en verre 3, d'une longueur comprise de préférence entre $\lambda/2$ et $\lambda/4$, étant la longueur de l'onde émise par le générateur haute fréquence; le réacteur est blindé sur toute ou partie de sa longueur,
- de deux pièces d'obturation 4 et 5 en métal conducteur comportant chacune une cavité 6 remplie de mercure et obturée par deux pièces munies de filières en rubis, diamant ou tout autre matière appropriée, permettant le passage de la fibre et empêchant l'écoulement du liquide, un joint torique 7 permet d'assurer l'étanchéité; les pièces 4 et 5 sont maintenus en place à l'aide de supports isolants; une cavité 15 permet l'admission ou l'évacuation du mélange réactif,
- d'un dispositif de déroulement du filament conducteur 8 permet de maintenir une tension mécanique constante de 0,5 à 5 gf à l'aide d'un électrofrein,
- d'une pièce 9, similaire à 4 et 5, reliée à la masse par un système capacitif, placée à une distance de l'ordre de $\lambda/4$ de la pièce de sortie et qui permet d'éviter que l'énergie haute fréquence ne s'échappe vers le dispositif d'enroulement,
- un système d'enroulement 10 permettant de tirer la fibre à travers le réacteur à vitesse constante,
- d'un système d'alimentation haute tension réglable II entre 0 et 2500 V et capable de délivrer une intensité de 250 à 350 mA; le couplage aux pièces 4 et 5 se fait par l'intermédiaire de deux selfs de choc L1 et L2 de deux condensateurs de découplage $C_1$ et $C_2$ — 1000 pf 6 KV — pour éviter un retour de l'énergie haute fréquence dans le générateur à courant continu,
- d'un dispositif d'alimentation haute fréquence 12 d'une puissance de 50 à 350 W et d'une fréquence telle que la longueur du réacteur soit comprise entre $\lambda/4$ et $\lambda/2$,
- d'un système d'adaptation 13 constitué par une ligne repliée de longueur règlable entre 0,1 et 1,2 $\lambda/4$ qui permet d'adopter la sortie du générateur à basse impédance $r=50\,\Omega$ à la charge constituée par la ligne. Un condensateur d'isolement $C_3$ de 1000 pf 6 KV isole l'alimentation HF du courant continu,
- d'un système de ventilation 14 permettant d'éviter un trop grand échauffement du mercure et de la fibre en sortie du réacteur.

Les exemples ci-après illustrent l'invention.

Exemple 1:

La conduite d'une opération s'effectue de la manière suivante:

- débit $H_2$ 300 l/H, $BCl_3$ 170 l/H
- substrat: tungstène de diamètre 12,7
- réacteur: longueur de 55 cm
- vitesse de défilement : 75 m/h
- fréquence du courant haute fréquence : 144 MHz.

On a effectué la série d'essais suivante pour démontrer la possibilité d'augmenter la puissance totale de chauffage avec l'augmentation de l'énergie haute fréquence. On fait varier la puissance haute fréquence de 0 à 225 W et la puissance en courant continu de 180 à 124 W et on obtient les résultats suivants:

| | | | | |
|---|---|---|---|---|
| — Puissance en courant continu | 178 W | 150 W | 136 W | 124 W |
| — Puissance en courant haute fréquence | 0 W | 90 W | 140 W | 215 W |
| — Puissance totale | 178 W | 240 W | 276 W | 339 W |
| — Diamètre de la fibre (µm) | 80 | 95 | 105 | 119 |
| — Résistance à la rupture (hb) | 344 | 356 | 339 | 360 |

Par adjonction du système de chauffage par HF on augmente la puissance de chauffage de 178 à 339 W et le diamètre de la fibre de 80 à 119 µm.

Exemple 2

Les débits gazeux, le substrat, la vitesse de défilement, le réacteur restent les mêmes que dans l'exemple 1. On fait varier le rapport puissance en courant haute fréquence/puissance en courant continu de manière à avoir une température de la fibre croissante de l'entrée à la sortie du réacteur.

On a alors les résultats suivants:

| | | | | |
|---|---|---|---|---|
| — Puissance en courant continu (W) | 149 | 103 | 103 | 103 |
| — Puissance en courant haute fréquence (W) | 0 | 100 | 150 | 200 |
| — Diamètre de la fibre (µm) | 84 | 77 | 90 | 104 |
| — Résistance à la rupture (hb) | 344 | 430 | 442 | 429 |
| — Profil thermique | décroissant | croissant | | |

L'obtention d'un profil croissant de température le long du filament conduit à des résistances à la rupture supérieures à celles obtenues avec un profil de température décroissant.

Dans le but d'accentuer le phénomène on procède alors à une expérience avec un tube réacteur de longueur 100 cm pour accentuer le profil de température avec les conditions suivantes:

- Puissance en courant haute fréquence : 100 W
- Puissance en courant continu : 180 W
- Profil thermique : voir ci-dessous

| | | | | | |
|---|---|---|---|---|---|
| Temperature (° C) | 1074 | 1074 | 1074 | 1140 | 1213 |
| Distance à la pièce d'entrée | 20 cm | 40 cm | 60 cm | 80 cm | 90 cm |

On obtient alors une fibre de diamètre 107 µm avec une résistance à la traction de 470 hb. Ainsi avec une très basse température dans la première partie du réacteur on obtient une fibre de résistance mécanique largement supérieure à celle obtenue par le procédé classique.

Exemple 3

Les conditions sont les mêmes que dans l'exemple 1, sauf le mélange réactif qui comporte des impuretés telles que $CoCl_2$, $CCl_4$ limitant les propriétés mécaniques de la fibre produite par le système conventionnel.

| | | | |
|---|---|---|---|
| — Puissance en courant continu (W) | 178 | 136 | 112 |
| — Puissance en courant haute fréquence (W) | 0 | 140 | 170 |
| — Diamètre de la fibre (μm) | 80 | 105 | 98 |
| — Résistance à la rupture (hb) | 230 | 339 | 361 |

Il est donc possible de fabriquer de la fibre, avec le système de chauffage par haute fréquence, en utilisant des matières premières inutilisables avec le procédé conventionnel.

**Revendications**

1. Procédé pour déposer en continu des matières réfractaires, notamment du bore, à partir d'un mélange gazeux décomposable par pyrolyse, sur un filament conducteur chauffé par effet Joule et défilant au travers d'un réacteur tubulaire caractérisé en ce qu'on augmente la température du filament dans une partie choisie du réacteur au moyen d'un courant haute fréquence injecté directement sur ledit filament.

2. Procédé pour déposer en continu des matières réfractaires, notamment du bore, selon la revendication 1, caractérisé en ce que la puissance produite par le courant haute fréquence varie de manière à augmenter la température du début à la fin du réacteur.

3. Procédé pour déposer en continu des matières réfractaires, notamment du bore, selon l'une quelconque des revendications 1 ou 2, caractérisé en ce que la puissance totale produite est supérieure à la puissance maximum que l'on peut produire par le courant continu.

4. Procédé pour déposer en continu des matières réfractaires, notamment du bore selon l'une quelconque des revendications 1 à 3, caractérisé en ce que le filament conducteur est le tungstène.

5. Procédé pour déposer en continu des matières réfractaires, notamment du bore, selon l'une quelconque des revendications 1 à 4,caractérisé en ce que ledit filament conducteur est chauffé par un courant haute fréquence directement injecté sur le filament au niveau du moyen de fermeture à la sortie du réacteur.

6. Appareillage pour effectuer le dépôt, à partir d'un mélange gazeux décomposable par pyrolyse, de matières réfractaires, notamment du bore, sur un filament conducteur chauffé par résistance et au moyen d'un chauffage par haute fréquence constitué, d'une chambre de réaction tubulaire, de moyens de fermeture aux deux extrémités de la chambre fonctionnant suivant le principe de la capillarité pour réaliser à la fois un scellage et un contact électrique en vue du chauffage, un moyen d'entrée pour fournir le mélange gazeux réactif à la chambre et un moyen de sortie pour évacuer les sous produits et l'excès de gaz réagissant, caractérisé en ce que le moyen de chauffage par haute fréquence est branché directement sur le filament conducteur.

7. Appareillage pour effectuer le dépôt, à partir d'un mélange gazeux décomposable par pyrolyse, de matières réfractaires, notamment du bore, sur un filament conducteur chauffé par résistance selon la revendication 6 caractérisé en ce que le moyen de chauffage haute fréquence est couplé au filament conducteur au niveau du moyen de fermeture, à la sortie du réacteur.

**Patentansprüche**

1. Verfahren zur kontinuierlichen Ablagerung von hitzebeständigen Stoffen, insbesondere Bor, ausgehend von einem durch Pyrolyse zersetzbaren Gasgemisch, auf einem Leitungsdraht, der durch Stromwärme erhitzt wird und einen rohrförmigen Reaktor durchläuft, gekennzeichnet durch Erhöhen der Drahttemperatur in einem gewählten Teil des Reaktors mittels eines am Draht unmittelbar eingeleiteten Hochfrequenzstroms.

2. Verfahren zur kontinuierlichen Ablagerung von hitzebeständigen Stoffen, insbesondere Bor, nach Anspruch 1, dadurch gekennzeichnet, daß die durch den Hochfrequenzstrom geleistete Arbeit derart variiert, daß die Temperatur vom Anfang bis zum Ende des Reaktors zunimmt.

3. Verfahren zur kontinuierlichen Ablagerung von hitzebeständigen Stoffen, insbesondere Bor, nach einem der Ansprüche 1 oder 2, dadurch gekennzeichnet, daß die gesamte geleistete Arbeit größer als die maximale Arbeit ist, die durch Gleichstrom erzeugt werden kann.

4. Verfahren zur kontinuierlichen Ablagerung von hitzebeständigen Stoffen, insbesondere Bor, nach einem der Ansprüche 1 bis 3, dadurch gekennzeichnet, daß der Leitungsdraht aus Wolfram besteht.

5. Verfahren zur kontinuierlichen Ablagerung von hitzebeständigen Stoffen, insbesondere Bor, nach einem der Ansprüche 1 bis 4, dadurch gekennzeichnet, daß der Leitungsdraht durch einen Hochfrequenzstrom erhitzt wird, der in Höhe der Verschlußeinrichtung am Ausgang des Reaktors unmittelbar am Draht eingeleitet wird.

6. Vorrichtung zur Durchführung der Ablagerung, ausgehend von einem durch Pyrolyse zersetzbaren Gasgemisch, von hitzebeständigen Stoffen, insbesondere Bor, auf einem Leitungsdraht, der durch Widerstand und Hochfrequenzerhitzung erhitzt wird, wobei die Vorrichtung gebildet ist durch eine rohrförmige Reaktionskammer, durch eine an beiden Enden der Kammer angeordnete Verschlußeinrichtung, die nach dem Prinzip der Kapillarität arbeitet zur gleichzeitigen Herstellung eines Verschlusses und elektrischen Kontakts im Hinblick auf die Erhitzung, durch eine Eintrittseinrichtung zur Lieferung des reaktiven Gasgemischs zur Kammer und durch eine Austrittseinrichtung zur Entleerung der Nebenprodukte und des Überschusses an Reaktionsgas, dadurch gekennzeichnet, daß die mit Hochfrequenz arbeitende Einrichtung unmittelbar am Leitungsdraht angeschlossen ist.

7. Vorrichtung zur Durchführung der Ablagerung, ausgehend von einem durch Pyrolyse zersetzbaren Gasgemisch, von hitzebeständigen Stoffen, insbesondere Bor, auf einem durch Widerstand erhitzten Leitungsdraht nach Anspruch 6, dadurch gekennzeichnet, daß die mit Hochfrequenz arbeitende Heizeinrichtung in Höhe der Verschlußeinrichtung am Austritt des Reaktors an den Leitungsdraht angeschlossen ist.

## Claims

1. Process for continuously depositing refractory materials, in particular boron, from a gaseous mixture, decomposable by pyrolysis, onto a conductive filament which is heated by means of the Joule effect and travels through a tubular reactor, characterised in that the temperature of the filament is increased in a chosen part of the reactor by means of a high-frequency current which is injected directly onto said filament.

2. Process for continuously depositing refractory materials, in particular boron, according to claim 1, characterised in that the power produced by the high-frequency current varies so as to increase the temperature from the inlet to the outlet of the reactor.

3. Process for continuously depositing refractory materials, in particular boron, according to either one of claims 1 or 2, characterised in that the total power produced is greater than the maximum power which can be produced ty the direct current.

4. Process for continuously depositing refractory materials, in particular boron, according to any one of claims 1 to 3, characterised in that the conductive filament is tungsten.

5. Process for continuously depositing refractory materials, in particular boron, according to any one of claims 1 to 4, characterised in that the said conductive filament is heated by means of a high-frequency current which is injected directly onto the filament at the level of the closing means at the outlet of the reactor.

6. Apparatus for depositing refractory materials, in particular boron, from a gaseous mixture, decomposable by pyrolysis, onto a conductive filament heated by resistance and high-frequency heating means said apparatus consisting of a tubular reaction chamber, closing means at the two ends of the chamber, which means function in accordance with the principle of capillarity in order to product a seal and simultaneously an electrical contact for the purpose of heating, an inlet means for supplying the reactive gaseous mixture to the chamber, and an outlet means for discharging the by-products and the excess reacting gas, characterised in that the high-frequency heating means is coupled directly to the conductive filament.

7. Apparatus for depositing refractory materials, in particular boron, from a gaseous mixture, decomposable by pyrolysis, onto a conductive filament heated by resistance, according to claim 6, characterised in that the high-frequency heating means is coupled to the conductive filament at the level of the closing means at the outlet of the reactor.

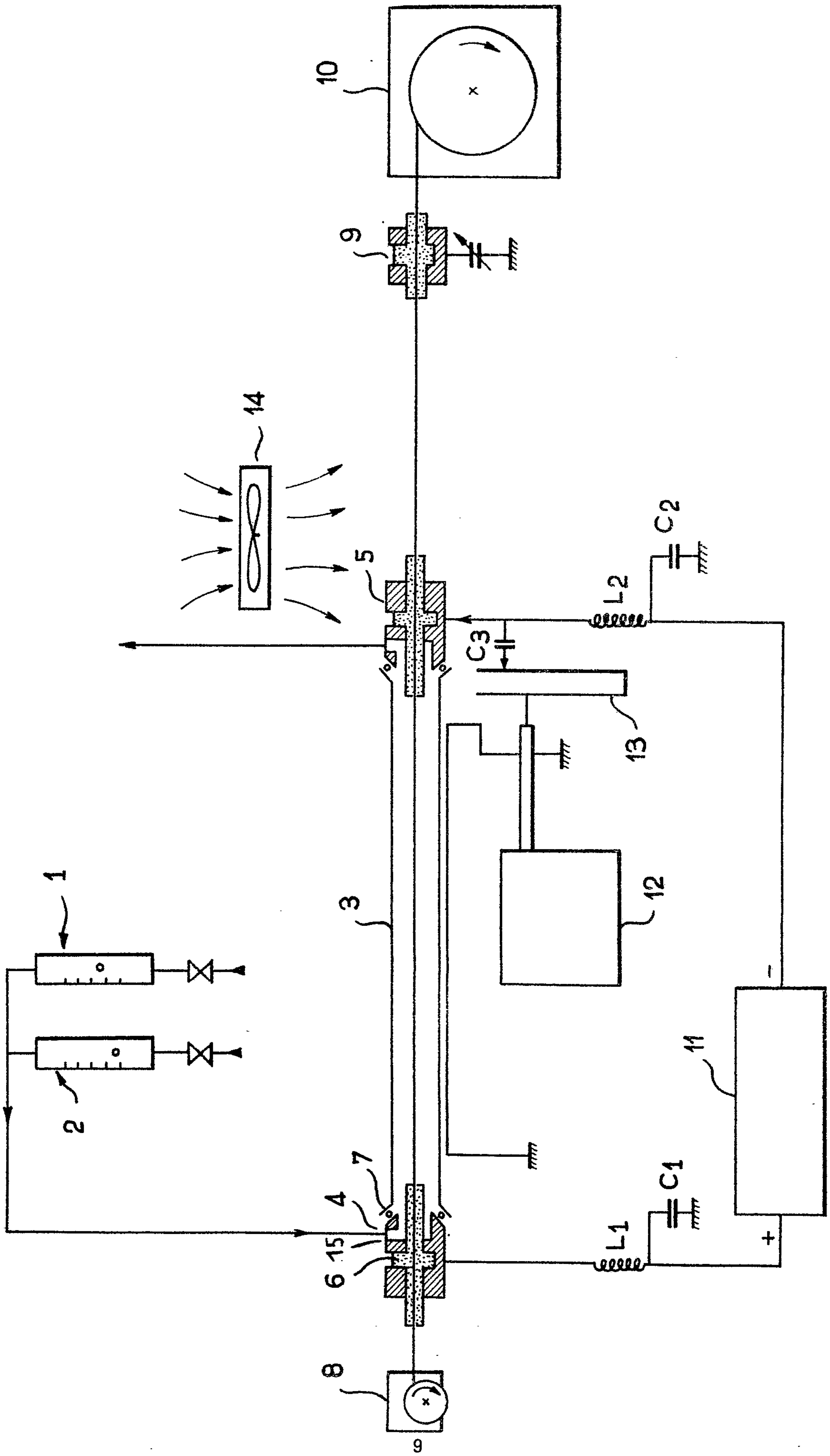

10
9
14
5
C2
L2
C3
13
3
1
12
2
11
7
4
15
6
C1
L1
8
+
−
9